# EUROPEAN PATENT APPLICATION

(11) **EP 4 016 512 A1**
(43) Date of publication of application: **22.06.2022**
(21) Application number: 20882716.2
(22) Date of filing: 21.10.2020
(51) Int. Cl.: G09G 3/3208, H01L 27/32

(54) **DISPLAY APPARATUS AND ELECTRONIC DEVICE**

(30) Priority: 31.10.2019 CN 201911050485
(71) Applicant: GUANGDONG OPPO MOBILE TELECOMMUNICATIONS CORP., LTD., Dongguan, Guangdong 523860 (CN)
(72) Inventor: LI, Liang, Dongguan, Guangdong 523860 (CN)
(74) Representative: Thorniley, Peter
(86) International application number: PCT/CN2020/122470
(87) International publication number: WO 2021/083003

(57) **Abstract**

Provided are a display apparatus and an electronic device. The display apparatus comprises a first display region and a second display region that are adjacent to each other, wherein the first display region comprises a plurality of first driving units, at least one first driving unit comprises at least two thin-film transistors, at least one thin-film transistor in the first driving unit is located in the first display region, and at least one thin-film transistor in the first driving unit is located in the second display region.

## Description

The present application claims priority to the China patent application No. 201911050485.4 submitted to the China Patent Office on October 31, 2019, titled "DISPLAY APPARATUS AND ELECTRONIC DEVICE", the entire contents of which are incorporated herein by reference.

### TECHNICAL FIELD

The present invention relates to electronic technologies, and more particularly to a display apparatus and an electronic device.

### BACKGROUND

With the development of communication technologies, electronic devices such as smart phones are becoming more and more popular. In using the electronic devices, the electronic devices can display images with their display screens.

In related arts, a sensor is disposed at a lower part of a display apparatus, and the sensor transmits signals passing through display apparatus. In addition, opaque components in the display apparatus, such as thin-film transistors, will reduce the light transmittance of the display apparatus, and the quality of signal transmission of the sensors is therefore affected.

### SUMMARY

The embodiments of the present application provide a display apparatus and an electronic device, which can improve the light transmittance of a first display region, and it benefits to improve the quality of transmitted signals of a sensor.

An embodiment of the present application provides a display apparatus, which includes a first display region and a second display region that are adjacent to each other,
wherein the first display region includes a plurality of first driving units, at least one of the first driving units includes at least two thin-film transistors, at least one thin-film transistor in the first driving unit is located in the first display region, and at least one thin-film transistor in the first driving unit is located in the second display region.

An embodiment of the present application further provides a display apparatus, which includes a first display region, the first display region including:
a first driving circuit layer and a second driving circuit layer that are stacked together; and
a plurality of first driving units, wherein at least one of the first driving units includes at least two thin-film transistors, at least one thin-film transistor in the first driving unit is located in the first driving circuit layer, at least one thin-film transistor in the first driving unit is located in the second driving circuit layer, the thin-film transistors in the first driving circuit layer are at least partially disposed with respect to the thin-film transistors in the second driving circuit layer.

An embodiment of the present application further provides an electronic device, including a display apparatus and a sensor, wherein the display apparatus is the afore-described display apparatus, and the sensor transmits signals passing through the first display region.

### BRIEF DESCRIPTION OF THE DRAWINGS

To describe the technical solutions in the embodiments of this application more clearly, the following briefly introduces the accompanying drawings required for describing the embodiments.
FIG. 1 is a schematic diagram illustrating the structure of an electronic device provided in an embodiment of the present application.
FIG. 2 is a schematic diagram illustrating the structure of a display apparatus provided in an embodiment of the present application.
FIG. 3 is a schematic diagram illustrating a first type of laminated structure of a first display region in a display apparatus provided in an embodiment of the present application.
FIG. 4 is a schematic diagram illustrating a first type of partial structure of a display apparatus provided in an embodiment of the present application.
FIG. 5 is an enlarged view of part X of the display apparatus in FIG. 4.
FIG. 6 is a schematic diagram illustrating a first-type circuit of a first driving unit of a display apparatus provided in an embodiment of the present application.
FIG. 7 is a schematic diagram illustrating a second-type circuit of a first driving unit of a display apparatus provided in an embodiment of the present application.
FIG. 8 is a schematic diagram illustrating a third-type circuit of a first driving unit of a display apparatus provided in an embodiment of the present application.
FIG. 9 is a schematic diagram illustrating a second type of partial structure of a display apparatus provided in an embodiment of the present application.
FIG. 10 is a schematic diagram illustrating a first type of structure of part Y of the display apparatus in FIG. 9.
FIG. 11 is a schematic diagram illustrating a second type of structure of part Y of the display apparatus in FIG. 9.
FIG. 12 is a schematic diagram illustrating a third type of structure of part Y of the display apparatus in FIG. 9.
FIG. 13 is a schematic diagram illustrating the structure of a first pixel and a first driving unit in a display apparatus provided in an embodiment of the present application.
FIG. 14 is a schematic diagram illustrating a third type of partial structure of a display apparatus provided in an embodiment of the present application.
FIG. 15 is a schematic diagram illustrating a third type of laminated structure of a first display region in a display apparatus provided in an embodiment of the present application.
FIG. 16 is a schematic diagram illustrating a fourth type of laminated structure of a first display region in a display apparatus provided in an embodiment of the present application.
FIG. 17 is a schematic diagram illustrating a second type of laminated structure of a first display region in a display apparatus provided in an embodiment of the present application.

### DETAILED DESCRIPTION

An embodiment of the present application provides a display apparatus, which includes a first display region and a second display region that are adjacent to each other,
wherein the first display region includes a plurality of first driving units, at least one of the first driving units includes at least two thin-film transistors, at least one thin-film transistor in the first driving unit is located in the first display region, and at least one thin-film transistor in the first driving unit is located in the second display region.

The display apparatus further includes a gate line, wherein the plurality of thin-film transistors of the first driving unit includes at least one driving transistor and at least one control transistor, and a gate of the control transistor is electrically connected to the gate line; and all of the driving transistors are disposed in the first display region and all of the control transistors are disposed in the second display region.

The display apparatus further includes a light-emitting layer, wherein the light-emitting layer includes a plurality of first pixels, the plurality of first driving units are configured to drive the plurality of first pixels, and an orthographic projection of the driving transistors onto the light-emitting layer at least partially overlaps with the first pixel.

A projection of the driving transistors onto the light-emitting layer is within the first pixel.

The first display region includes a plurality of first pixel sets, each of the first pixel sets includes at least two of the first pixels, and one first driving unit is configured to drive all of the first pixels in one first pixel set.

All of the first pixels in each of the first pixel sets are connected in parallel to one another.

The second display region includes a plurality of second pixels, and the first pixels and the second pixels have a same physical structure.

The first driving unit further includes a capacitor located in the first display region.

Light transmittance of the first display region is greater than light transmittance of the second display region.

The first display region includes a plurality of first pixels, the second display region includes a plurality of second pixels, and a size of the first pixels is greater than a size of the second pixels.

The first display region includes a plurality of first pixels, the second display region includes a plurality of second pixels, and distribution density of the first pixels is less than distribution density of the second pixels.

The second display region includes second driving units, the second driving units drive the plurality of second pixels, and a number of thin-film transistors of the second driving unit is greater than or equal to a number of thin-film transistors of the first driving unit.

An embodiment of the present application further provides a display apparatus, which includes a first display region, the first display region including:
a first driving circuit layer and a second driving circuit layer that are stacked together; and a plurality of first driving units, wherein at least one of the first driving units includes at least two thin-film transistors, at least one thin-film transistor in the first driving unit is located in the is first driving circuit layer, at least one thin-film transistor in the first driving unit is located in the second driving circuit layer, the thin-film transistors in the first driving circuit layer are at least partially disposed with respect to the thin-film transistors in the second driving circuit layer.

The display apparatus further includes a gate line, the plurality of thin-film transistors of the first driving unit are divided into driving transistors and control transistors, a gate of the control transistor is electrically connected to the gate line, each of the driving transistors is located in the is first driving circuit layer, and each of the control transistors is located in the second driving circuit layer.

The display apparatus further includes a light-emitting layer, wherein the light-emitting layer includes a plurality of first pixels, and the plurality of first driving units are configured to drive the plurality of first pixels; and
the first driving circuit layer is located between the light-emitting layer and the second driving circuit layer.

The first display region includes a plurality of first pixel sets, each of the first pixel sets includes at least two of the first pixels, and one first driving unit is configured to drive all of the first pixels in one first pixel set.

All of the first pixels in each of the first pixel sets are connected in parallel to one another.

The second display region includes a plurality of second pixels, and the first pixels and the second pixels have a same physical structure.

The display apparatus further includes a second display region adjacent to the first display region, wherein light transmittance of the second display region is less than light transmittance of the first display region.

An embodiment of the present application further provides an electronic device, including a display apparatus and a sensor, wherein the display apparatus is the display apparatus according to any of above embodiments, and the sensor transmits signals passing through the first display region.

The embodiments of the present application provide an electronic device and a display apparatus thereof. The electronic device may include a display apparatus and a camera. The lens of the camera is disposed with respect to the display apparatus, that is, the camera captures external light signals passing through the display apparatus for forming an image. It can be understood that a conventional display apparatus has low light transmittance, and therefore the imaging via the display apparatus by the camera has a poor effect. For this reason, the display apparatus may have an arrangement of separate regions in the embodiments of the present application. For example, the light transmittance of a portion of the display apparatus corresponding to the camera is set to be greater than the light transmittance at other positions of the display apparatus. This can improve the imaging effect of the camera. The technical solutions in the embodiments of the present application will be clearly and completely described below with reference to appended drawings of the embodiments of the present application.

The electronic devices provided in the embodiments of the present application can be mobile terminal devices, such as mobile phones and tablet computers, and can also be devices having a display apparatus, such as gaming devices, augmented reality (AR) devices, virtual reality (VR) devices, on-board computers, laptop computers, data storage devices, audio playback devices, video playback devices and wearable devices. Among them, the wearable devices can be smartbands, smart glasses, etc.

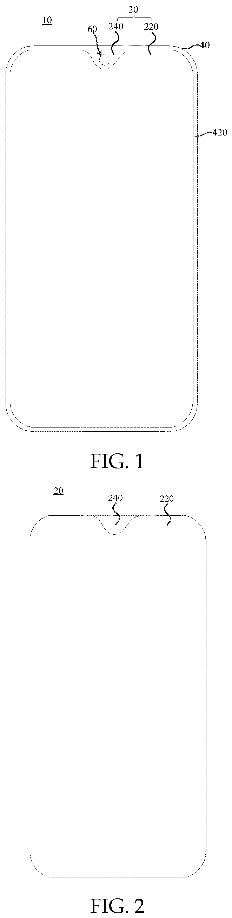

FIG. 1 is a schematic diagram illustrating the structure of an electronic device provided in an embodiment of the present application. FIG. 1 shows a mobile phone taken as an example of the electronic device. The display apparatus 20 includes a first display region 240 and a second display region 220. The light transmittance of the first display region 240 is greater than the light transmittance of the second display region 220. The electronic device 10 is provided with a sensor such as a camera 60. The sensor is configured to transmit signals passing through the first display region 240. For example, the sensor is a camera 60. The lens of the camera 60 is disposed facing the first display region 240, and the camera 60 is configured to capture external light signals passing through the first display region 240 for forming an image. It can also be understood that the camera 60 is disposed at a lower part of the first display region 240 of the display apparatus 20, and the camera 60 is configured to obtain external light signals passing through the first display region 240 of the display apparatus 20 and form an image based on the captured external light signals. The display region of the display apparatus 20 is sound and complete, thereby increasing the screen-to-body ratio of the display apparatus 20. The camera 60 can be used as a front camera of the electronic device. The camera 60 can be configured to capture an image, such as a user's selfie, passing through the first display region 240 of the display apparatus 20. The sensor may be at least one of a camera, a proximity sensor, a light sensor, a rangefinder or a fingerprint recognition sensor.

In order to have a more comprehensive understanding of the display apparatus in the embodiment of the present application, the display apparatus will be described in detail below.

FIG. 2 is a schematic diagram illustrating the structure of a display apparatus provided in an embodiment of the present application. The display apparatus 20 in the embodiment of the present application may include a first display region 240 and a second display region 220 that are adjacent to each other.

Both the first display region 240 and the second display region 220 can be used to display text or images. The first display region 240 and the second display region 220 can together display a same image, for example, the second display region 220 displays a part of a predetermined image and the first display region 240 displays the rest of the predetermined image. The second display region 220 and the first display region 240 can also display different images, for example, the second display region 220 displays a predetermined image and the first display region 240 displays a task bar image. Both the second display region 220 and the first display region 240 can display contents. The overall display region is complete, and the display apparatus 20 has a high screen-to-body ratio. The second display region 220 may surround the first display region 240. The periphery of the first display region 240 may be all adjacent to the second display region 220, that is, the first display region 240 is located in the middle of the second display region 220. The second display region 220 may also partially surround the first display region 240. A part of the periphery of the first display region 240 is adjacent to the second display region 220, for example, the first display region 240 is located at a corner of the display apparatus 20 or in the middle of a top portion of the display apparatus 20.

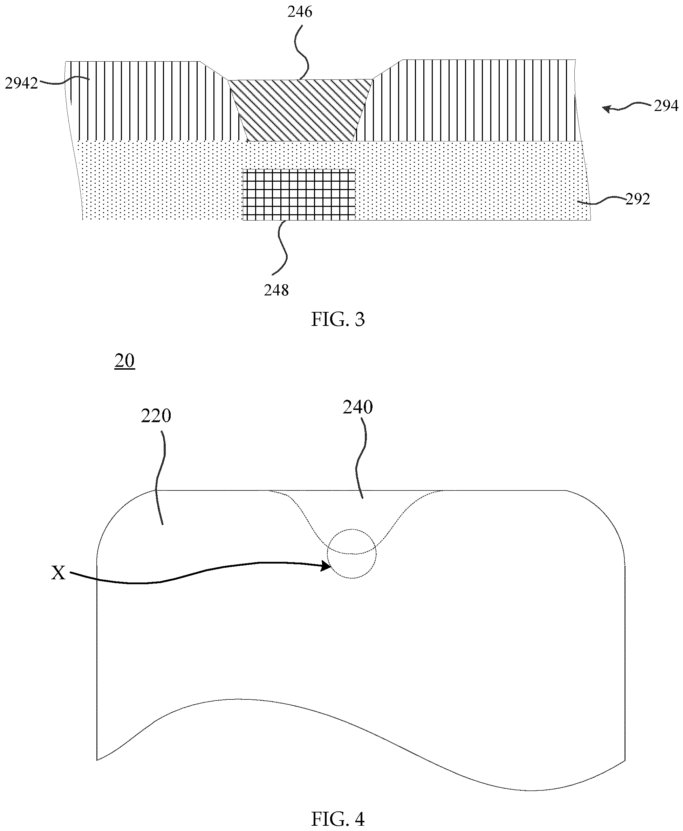

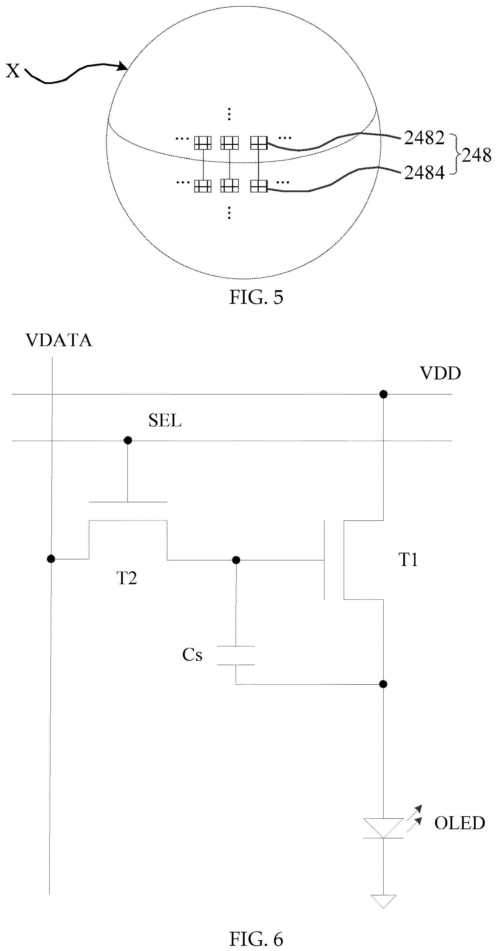

Please refer to FIGs. 3 to 5. FIG. 3 is a schematic diagram illustrating a first type of laminated structure of a first display region in a display apparatus provided in an embodiment of the present application. FIG. 4 is a schematic diagram illustrating a first type of partial structure of a display apparatus provided in an embodiment of the present application. FIG. 5 is an enlarged view of part X of the display apparatus in FIG. 4. It needs to be noted that FIG. 5 merely shows a part of first driving units. The first display region 240 of the display apparatus 20 includes a light-emitting layer 294 and a driving circuit layer 292 that are stacked. The first display region 240 includes a plurality of first driving units 248. At least one of the first driving units 248 includes at least two thin-film transistors. At least one thin-film transistor in the first driving unit 248 is located in the first display region 240, and at least one thin-film transistor in the first driving unit 248 is located in the second display region 220. Each first driving units 248 may include at least two thin-film transistors. At least one thin-film transistor 2482 in any one of the first driving units 248 is located in the first display region, and at least one thin-film transistor 2484 in any one of the first driving units 248 is located in the second display region. At least one opaque thin-film transistor in the first driving unit 248 is located in the second display region outside the first display region such that the light transmittance of the first display region 240 is improved. In this way, more external light signals can be captured by the camera disposed with respect to the first display region 240, thereby improving the quality of imaging of the camera.

The display apparatus may further include a light-emitting layer 294. The light-emitting layer 294 may include a pixel definition layer 2942. The pixel definition layer 2942 includes a pixel hole, and a first pixel 246 is provided in the pixel hole. The first driving unit 248 is configured to drive the first pixel 246.

At least one thin-film transistor in the first driving unit 248 is located in the first display region 240, and at least one thin-film transistor in the first driving unit 248 is located in the second display region 220 outside the first display region 240. It can be understood that the camera is configured to capture external light signals passing through the first display region 240 for forming an image. Some opaque thin-film transistors are disposed outside the first display region 240. The number of opaque thin-film transistors in the first display region 240 is reduced. This can increase the light transmittance of the first display region.

There are a plurality of first pixels in the first display region. There are also a plurality of first driving units in the first display region. The plurality of first driving units drive the plurality of first pixels to obtain a better display effect.

The display apparatus also includes gate lines (not shown) and data lines (not shown). The gate lines, the data lines and the first driving units cooperate with one another to drive each of the first pixels. The gate lines and the data lines may be arranged in different layers and arranged in an interlacing fashion, for example, the gate lines are arranged in rows and the data lines are arranged in columns.

In order to have a more comprehensive understanding of the deployment of the thin film transistor of the first driving unit in the embodiments of the present application, the first driving units are illustrated below by 7T1C, 5T2C and 2T1C.

FIG. 6 is a schematic diagram illustrating a first-type circuit of a first driving unit of a display apparatus provided in an embodiment of the present application. The first driving unit may be 2T1C. The first driving unit may include a plurality of thin-film transistors (T1 and T2). The plurality of thin-film transistors may be classified into a driving transistor T1 and a control transistor T2. The gate of each control transistor T2 is electrically connected to a gate line SEL. It can also be understood that the plurality of thin-film transistors in each of the first driving units can be classified into two types, one of which is a driving transistor and the other one of which is a control transistor. If the gate of the thin-film transistor in each first driving unit is electrically connected to the gate line SEL, it is a control transistor T2. The thin-film transistor in each first driving unit except the control transistor T2 is a driving transistor T1.

The driving transistor T1 is disposed in the first display region, and the control transistor T2 is disposed in the second display region outside the first display region. Each first pixel in the first display region is connected to a power supply voltage via a wire. The longer the wire length, the greater the resistance of the wire. Inevitably, a voltage drop (IR DROP) will be caused on the wire for the power supply voltage. The resistance of the wire makes the power supply voltage obtained by each first driving unit different such that in the presence of a same data signal voltage input, the first pixels have different currents and different brightness outputs. The entire display apparatus results in uneven display brightness. Also, the IR drop of the first pixels may differ for different displayed images. The control transistor in the first driving unit plays a control role and is not sensitive to the IR drop. When the control transistor is placed outside the first display region, it does not affect turning on and off the control transistor and has no effect on color compensation of the first display region even though the IR drop of the power supply voltage and the voltage signal of the control transistor is large. The driving transistor in the first driving unit plays a role of driving the first pixel. When the driving transistor is disposed in the first display region, the voltage drop (IR Drop) will be relatively small since it is close to the first pixel, that is, it is easier to compensate the color of the first display region when the IR drop of the power supply voltage and the voltage signal of the first pixel is small.

It needs to be noted that Cs in the first driving unit is disposed adjacent to the driving transistor, that is, both the Cs and the driving transistor T1 are disposed in the driving circuit layer of the first display region.

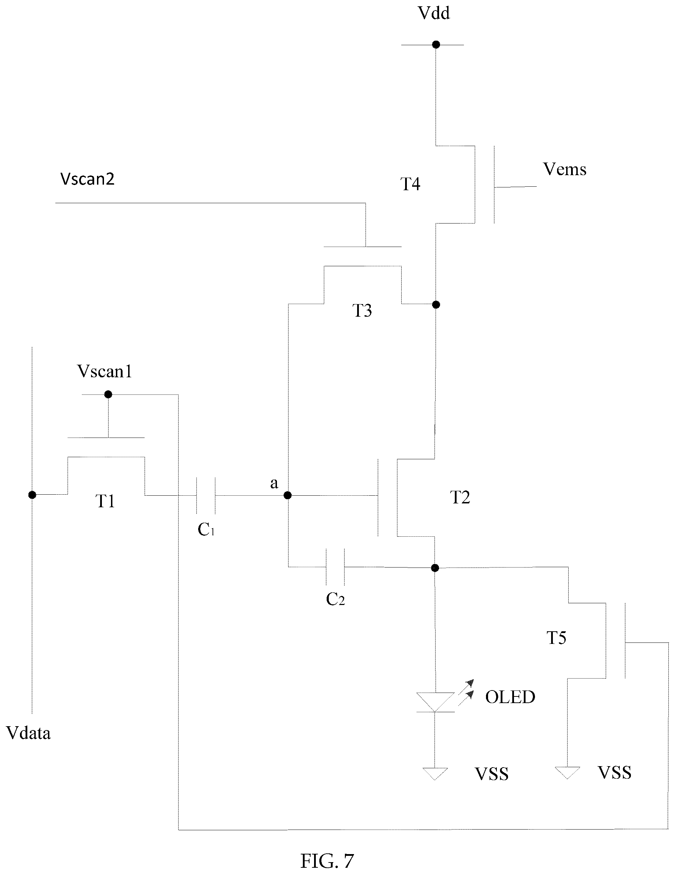

The first driving unit may also be 5T2C. Please refer to FIG. 7 for details. FIG. 7 is a schematic diagram illustrating a second-type circuit of a first driving unit of a display apparatus provided in an embodiment of the present application. T1, T3 and T5 in the first driving unit are control transistors, and T2 and T4 in the first driving unit are driving transistors. In the figure, Vscan1 and Vsacan2 are connected to different gate lines, Vdata is connected to a data line, Vdd is connected to a voltage source, Vems is connected to a light-emitting scan control line, and OLED is a pixel.

The basic working principle of the first driving unit in the case of 5T2C can be illustrated as follows:

Reset stage: T1 is on, T4 is on, T3 is on, T2 is on, T5 is on, and the current flows through T3 and T4 to charge the capacitor C2. Because T5 is on, the OLED does not emit light.

Threshold voltage storing stage: T1, T2, T3 and T5 are turned on, T4 is turned off, and Vdata is 0. The voltage at point a is discharged to be Va=Vth via T3, T2 and T5. Since T5 is turned on, the OLED does not emit light. Vth is the threshold voltage of the thin-film transistor.

Data voltage writing stage: T1, T2 and T5 are turned on, T3 and T4 are turned off, the gray-scale data voltage jumps to a positive value, and the gray-scale data is coupled to T2 via C1. Meanwhile, Va=Vth+Vdata*C1/( C1+C2). Because T5 is turned on, the OLED does not emit light.

Light-emitting stage: T2 and T4 are turned on, T1, T3 and T5 are turned off, and T2 drives the OLED to emit light. The voltage Va=Vth+Vdata*C1/(C1+C2) stored in C2 keeps unchanged, thereby keeping the brightness of the OLED unchanged for one frame.

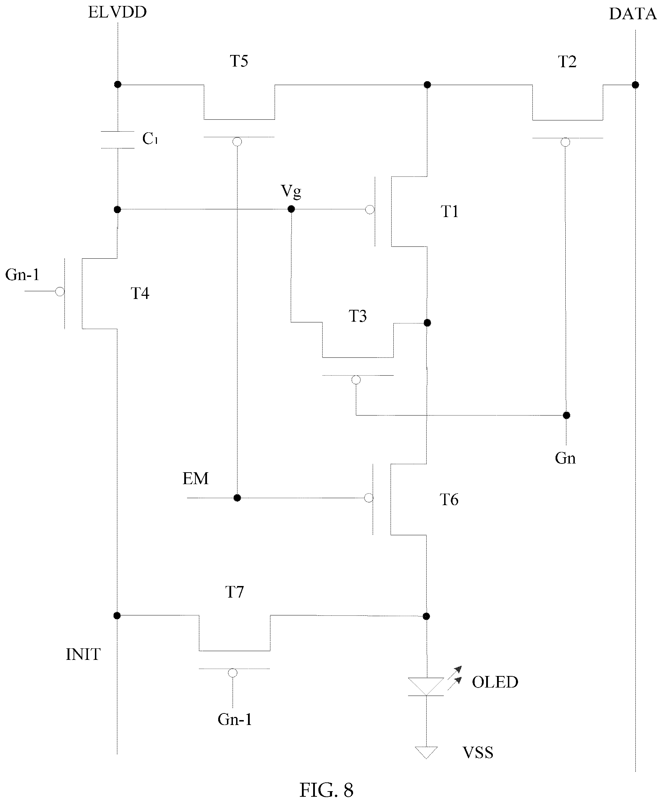

The first driving unit may also be 7T1C. Please refer to FIG. 8 for details. FIG. 8 is a schematic diagram illustrating a third-type circuit of a first driving unit of a display apparatus provided in an embodiment of the present application. T2, T3, T4 and T7 in the first driving unit are control transistors, and T1, T5 and T6 in the first driving unit are driving transistors. In the figure, Gn-1 and Gn are connected to different gate lines, DATA is connected to a data line, ELVDD is connected to a voltage source, and EM is connected to a light-emitting scan control line.

It needs to be noted that the capacitors C1 and C2 in the first driving unit are disposed adjacent to the driving transistors, that is, the capacitors C1 and C2 and the driving transistors T2 and T4 are all disposed in the driving circuit layer of the first display region.

The basic working principle of the first driving unit in the case of 7T1C can be illustrated as follows:

Capacitor discharging stage: Gn-1 is at a low level, T4 is turned on, INIT is a low level, and capacitor C1 is discharged.

Compensation stage: Gn is at a low level, T2 and T3 are turned on, the drain and gate of T1 are short-circuited, and Vg>Vth, T1 is turned on until vg=Vdata-Vth. Vth is the threshold voltage of the thin-film transistor.

Light-emitting stage: EM is at a low level, T5 and T6 are turned on, and Vgs=ELVDD-(Vdata-Vth).

T2, T3, T4, and T7 are used for resetting and controlling, and the actual driving paths are directed to T1, T5, and T6. The first driving unit in the case of 7T1C can get rid of Vth diversion of the thin-film transistor in the 2T1C driving circuit and solve the problem of uneven brightness of the display apparatus.

It needs to be noted that that the capacitor C1 in the first driving unit is disposed adjacent to the driving transistors, that is, the capacitor C1 and the driving transistors T1, T5 and T6 are all disposed in the driving circuit layer of the first display region.

Referring to FIG. 2 again, the second display region 220 of the display apparatus 20 is configured to provide information such as image and text information. The camera does not need to capture external light signals with help of the second display region 220, and it does not need to consider the light transmittance for the second display region 220. Therefore, the thin-film transistors located outside the first display region 240 can be disposed in the second display region 220. The gaps in the second display region 220 are used to accommodate the thin-film transistors of the first driving units located outside the first display region 240.

It needs to be noted that the greater the distribution density of second pixels in the second display region 220 of the display apparatus 20 is, the more the second pixels per unit area are, the higher the resolution is and the better display effect is provided. In the manufacture process of the display apparatus 20, the size of the second pixel in the second display region 220 corresponds to the size of the second driving unit driving the second pixel. The plurality of second driving units also need a plurality of control lines to be connected to a driving chip of the display apparatus 20. The driving chip controls each of the second driving units by the plurality of control lines. The plurality of control lines are disposed between the plurality of second driving units. There are gaps between the second pixels, and the gaps are disposed corresponding to the control lines. The control lines have a certain line width, which needs to satisfy the needs of impedance and product manufacture. For example, the pixel density of the second display region 220 can reach 400 ppi or more, and the size of the second pixel in the second display region 220 is approximately as the same as the size of the second driving unit. The second driving unit is disposed below the second pixel correspondingly. The plurality of control lines are arranged between the plurality of second driving units and are correspondingly disposed below the gaps between the second pixels. The second driving units and the control lines connected therewith basically cover a whole layer, and it is difficult to accommodate other components.

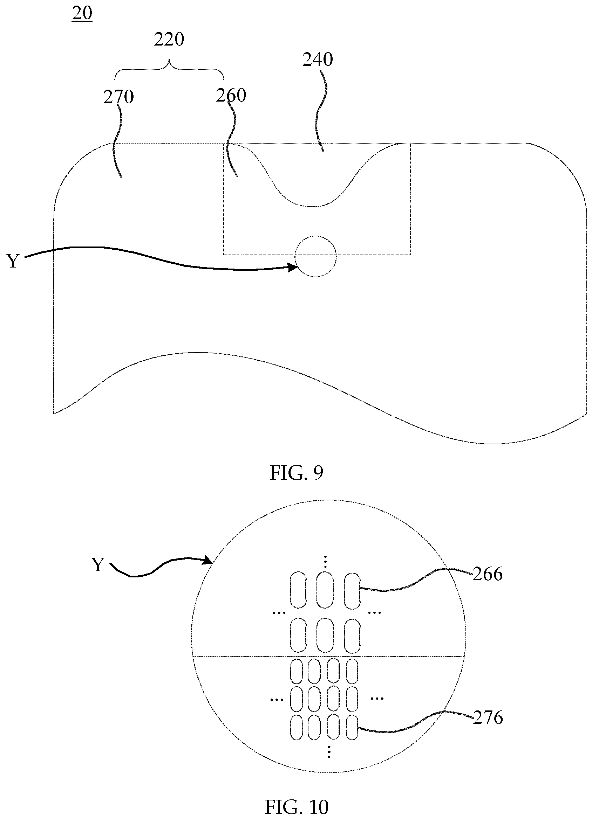

The second display region may include a third display region adjacent to the first display region. Please refer to FIG. 9 for details. FIG. 9 is a schematic diagram illustrating a second type of partial structure of a display apparatus provided in an embodiment of the present application. The second display region may include a third display region 260 and a fourth display region 270, and the thin-film transistor of the first driving unit located outside the first display region may be located in the third display region 260.

FIG. 10 is a schematic diagram illustrating a first type of structure of part Y of the display apparatus in FIG. 9. The size of third pixels 266 of the third display region 260 may be greater than the size of the fourth pixels 276 of the fourth display region 270. The spacing between the third pixels 266 is positively correlated with the size of the third pixels 266. If transition driving units of the third display region 260 and the second driving units 228 belong to a same driving circuit, the size of the transition driving units is equal to or slightly larger than the size of the second driving units 228. The control lines connected to the transition driving units have line width that is approximately equal to the line width of the control lines connected to the second driving units 228. The size of the transition driving units in the third display region 260 is smaller than the size of the third pixels 266. Therefore, a layer in the third display region 260 for disposing the transition driving units has an accommodating room, which can be used to receive the thin-film transistors of the first driving units outside the first display region. It needs to be noted that the fourth pixels in this embodiment can be understood as the second pixels in the foregoing embodiments.

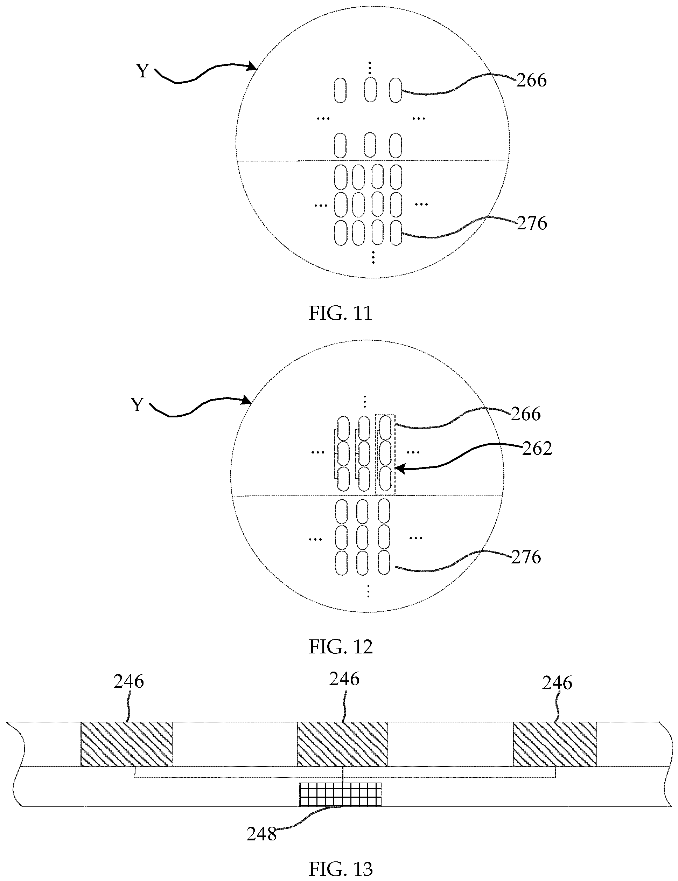

FIG. 11 is a schematic diagram illustrating a second type of structure of part Y of the display apparatus in FIG. 9. The size of the third pixels 266 of the third display region 260 may be equal to the size of the fourth pixels 276 of the fourth display region 270. However, the spacing between the third pixels 266 is greater than the spacing between the fourth pixels 276. If the transition driving units of the third display region 260 and the second driving units 228 belong to a same driving circuit, a layer in the third display region 260 for disposing the transition driving units has an accommodating room because the spacing between the third pixels 266 is relatively large. The accommodating room can be used to receive the thin-film transistors of the first driving units outside the first display region. It needs to be noted that the fourth pixels in this embodiment can be understood as the second pixels in the foregoing embodiments.

The size of the third pixels 266 of the third display region 260 may be equal to the size of the fourth pixels 276 of the fourth display region 270. Also, the spacing between the third pixels 266 is equal to the spacing between the fourth pixels 276. However, the transition driving units of the third display region 260 can belong to a driving circuit that is simpler than the second driving units. For example, the transition driving units are of a 2T1C type or a 5T1C type, and the second driving units are of a 7T1C type. Because the thin-film transistors included in the transition driving unit is less in number and less space is occupied, a layer in the third display region 260 for disposing the transition driving units has an accommodating room, which can be used to receive the thin-film transistors of the first driving units outside the first display region.

Please refer to FIG. 12 with reference to FIG. 13. FIG. 12 is a schematic diagram illustrating a third type of structure of part Y of the display apparatus in FIG. 9. FIG. 13 is a schematic diagram illustrating the structure of a first pixel and a first driving unit in a display apparatus provided in an embodiment of the present application. The third pixels 266 of the third display region 260 can be divided into a plurality of second pixel sets 242, that is, the third display region 260 includes a plurality of second pixel sets 242, and each of the second pixel sets 242 includes at least two third pixels 266 connected in parallel with each other. The third pixels 266 and the fourth pixels may have a same physical structure. All the third pixels 266 in the second pixel set 242 share a transition driving unit. The light-emitting layer in the third display region and the fourth display region can be formed in a same process, and there is no difference between the light emitting layer of the third display region and the light-emitting layer of the fourth display region. In the fourth display region, one master driving unit drives one fourth pixel. In the third display region, one transition driving unit drives a plurality of third pixels 266 connected in parallel with one another. This can reduce the number of the transition driving units and reduce the distribution density of the transition driving units. The number of the transition driving units per unit area is smaller than the number of the master driving units per unit area. A layer in the third display region 260 for disposing the transition driving units has an accommodating room, which can be used to receive the thin-film transistors of the first driving units outside the first display region.

The third pixels and the fourth pixels have a same physical structure, and this can be understood as a meaning that the third pixels and the fourth pixels have a same size, a same distribution density or a same arrangement. The arrangement can be one of a standard RGB arrangement, a Pentile arrangement or a Delta arrangement.

Connecting the third pixels in parallel can be realized by connecting the third pixels in parallel in the light-emitting layer and can also be realized by connecting metal anodes in an anode layer in parallel.

Of course, the third pixels and the fourth pixels may also have different physical structures. For example, the distribution density of the third pixels is smaller than the distribution density of the fourth pixels, the size of the third pixels is larger than the size of the fourth pixels, or the third pixels are arranged in a standard RGB arrangement and the fourth pixels are arranged in a Pentile arrangement.

In addition, the third pixels in the third display region and the fourth pixels in the fourth display region may have a same physical structure, that is the third pixels and the fourth pixels have a same size, a same spacing between the pixels and a same arrangement of the pixels. The pixels per inch (PPI) of the third display region is reduced such that a layer in the third display region 260 for disposing the transition driving units has an accommodating room, which can be used to receive the thin-film transistors of the first driving units outside the first display region. The method of reducing the PPI may include at least one of increasing the size of the third pixels or increasing the spacing between the third pixels. The third pixels and the fourth pixels can be formed in a same process. There is no need to form pixels with different physical structures by using different processes. The first pixels may also have a physical structure as the same as the third pixels such that all the pixels of the display apparatus are formed in a same process. Of course, the first pixels and the third pixels may have different physical structures.

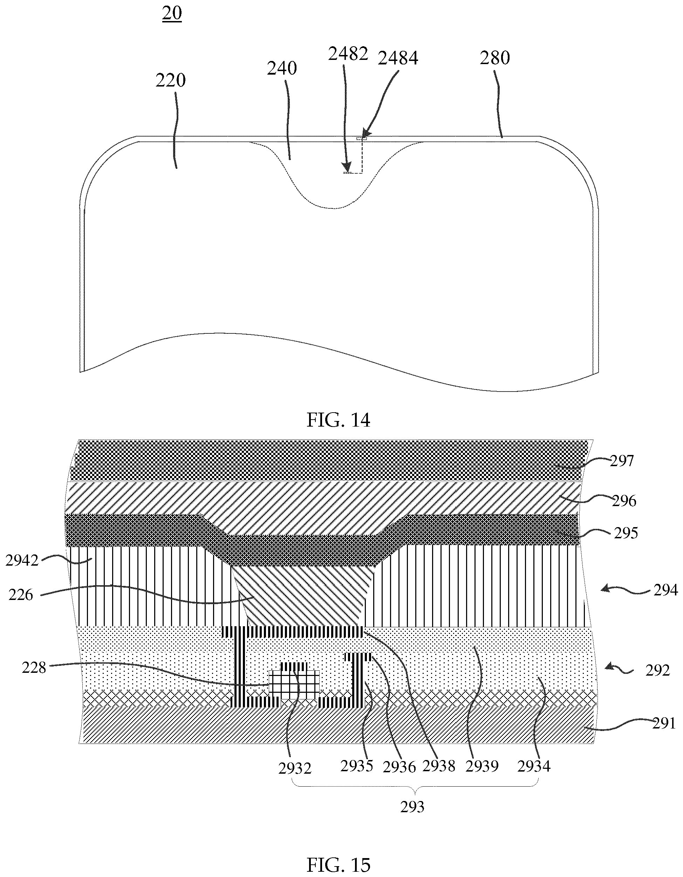

The thin-film transistors located outside the first display region can also be disposed in a non-display region in addition to being disposed in the second display region. Please refer to FIG. 14 for details. FIG. 14 is a schematic diagram illustrating a third type of partial structure of a display apparatus provided in an embodiment of the present application. The display apparatus 20 may further include a non-display region 280. Some of the thin-film transistors (e.g., the control transistors 2484) of the first driving unit 248 driving the first pixel 246 of the first display region 240 may also be disposed in the non-display region 280. Some of the thin-film transistors (e.g., the driving transistors 2482) of the first driving unit 248 are disposed in the first display region 240. The display apparatus 20 may be a full-screen display, that is, basically, the entire front face of the display apparatus 20 is the display region. From the perspective of the front face of the electronic device, the front face of the display apparatus 20 is basically equivalent to the entire display surface of the electronic device. However, even if it is a full-screen display apparatus 20, it will still have a non-display region at the periphery of the display apparatus 20. The non-display region can be understood as a black border of the display apparatus 20. The black border can have a very narrow width, for example, the width of the black border is less than 1 mm or 0.5 mm. Because the area of the first display region 240 is small and the number of the first pixels 246 in the first display region 240 is also small, the first driving units 248 driving the first pixels 246 of the first display region 240 are small in number. Some of the thin-film transistors (e.g., the control transistors 2484) of the first driving unit 248 can be disposed at the black border to increase the light transmittance of the first display region 240 without affecting the second display region 220. It needs to dispose a plurality of first driving units 248 corresponding to the first pixels 246 in the first display region 240. Some of the thin-film transistors (e.g., the control transistors 2484) of each of the first driving units 248 can be all disposed at the black border. In order to better accommodate the thin-film transistors of all of the first driving units 248 at the black border, a simple first driving unit 248 can be used, for example, a 2T1C or 5T1C driving circuit can be utilized as the first driving unit 248 such that the number of the thin-film transistors that need to be placed at the black border in each first driving unit 248 is small. It is also possible to arrange the distribution density of the first pixels 246 in the first display region 240 to be low such that the total number of the first driving units 248 in the first display region 240 is small. It needs to be noted that the thin-film transistors located outside the first display region may be partly disposed in the non-display region 280 and partly disposed in the first display region 240.

It is considered that the width of the black border is very small and the control transistors 2484 may not be all accommodated. Accordingly, some of the control transistors 2484 can be disposed at the black border and some of the control transistors can be disposed in the second display region or the first display region.

It needs to be noted that the control transistors disposed at the black border is also in a layer as the same as the driving transistors of the driving circuit layer of the first display region.

The first display region also includes metal anodes, which are adjacent to the first pixels. The metal anodes in the first display region can be made of a highly reflective material (e.g., metallic magnesium, magnesium alloy, etc.) for increasing the display brightness of the first display region. The metal anodes are disposed at a lower part of the first pixels. The light transmittance of the metal anodes is relatively low. Disposing the driving transistors 2482 under the first pixels is equivalent to disposing the driving transistors 2482 below the metal anodes such that the light signals passing through the pixel definition layer will not be shielded by the driving transistors 2482, thereby improving the overall light transmittance of the first display region.

It needs to be noted that if the first driving unit is of a 7T1C type, the area of the first driving unit of the 7T1C type is relatively large, it cannot be fully disposed under the metal anode and the metal anode cannot cover a corresponding first driving unit. It can also be understood as a meaning that the area of a projection of the metal anode onto the driving circuit layer is smaller than the area of the first driving unit. The control transistors in the first driving unit are disposed in the second display region, and the driving transistors in the first driving unit are disposed beneath the metal anode of the first display region. In this way, the area occupied by the driving transistors is significantly smaller than that of the first driving unit such that the driving transistors can be completely disposed beneath the metal anode, thereby increasing the light transmittance of the first display region.

The metal anodes in the first display region can also be made of a material with high light transmittance (e.g., ITO) for increasing the light transmittance of the first display region. The metal anodes are disposed at a lower part of the first pixels. The light transmittance of the metal anodes and the first pixels is lower than the light transmittance of the pixel definition layer. Disposing the driving transistors 2482 under the first pixels is equivalent to disposing the driving transistors 2482 below the metal anodes such that the light signals passing through the pixel definition layer will not be shielded by the driving transistors 2482, thereby improving the overall light transmittance of the first display region.

Please refer to FIG. 15 in order to have a more comprehensive understanding of the display apparatus of the embodiments of the present application. FIG. 15 is a schematic diagram illustrating a third type of laminated structure of a second display region in a display apparatus provided in an embodiment of the present application. The display apparatus includes a substrate 291, a first driving circuit layer 298, an anode layer 293, a light-emitting layer 294, a common electrode layer 295, a planarization layer 296 and a touch sensitive layer 297 that are stacked in order in the second display region.

The substrate 291 can be used as a carrier platform of the display apparatus. The substrate 291 can be made of glass, plastic, resin, or other materials. For example, the material of the substrate 291 may be polyimide (PI).

The first driving circuit layer 298 is disposed on the substrate 291. The first driving circuit layer 298 includes the second driving units 228 for driving the second pixels 226 in the second display region 220. Each second driving unit 228 includes at least one thin-film transistor TFT. The source and the drain of the thin-film transistor are located in a same layer, and the gate of the thin-film transistor is located between the source and the light-emitting layer.

The anode layer 293 is disposed on the first driving circuit layer 298. The anode layer 293 includes a first anode layer 2932, a first insulating layer 2934, and a second anode layer 2936. The first insulating layer 2934 is disposed between the first anode layer 2932 and the second anode layer 2932 and is used to separate and insulate the first anode layer 2932 and the second anode layer 2936. The first anode layer 2932 includes a first signal line (gate line) in a first direction, and the second anode layer 2936 includes a second signal line (data line) in a second direction. The first direction and the second direction can be arranged to be perpendicular to each other. The first signal line and the second signal line are electrically connected to the second driving unit 228, and the driving chip of the display apparatus controls the second driving unit 228 through the first signal line and the second signal line. The first signal line and the second signal line may be made of a metal or alloy material such as molybdenum, molybdenum/aluminum/molybdenum, and Ag. The first signal line and the gate of the second driving unit 268 may be located in a same layer. The second signal line may be electrically connected to the drain of the second driving unit 228 via a conductive portion located inside a first via 2935. The anode layer 293 may also include a metal anode layer. The metal anode layer is adjacent to the light-emitting layer 294. The metal anode 2938 of the metal anode layer and the second pixel 226 of the light-emitting layer 294 are directly adjacent to each other and are electrically connected to each other. There is a second insulating layer 2939 between the metal anode layer and the source of the second driving unit 228. The metal anode 2938 can be electrically connected to the source of the second driving unit 228 via a conductive part located inside a pixel via. The metal anode 2938 can be made of a material such as Mg, Ag and Al. It needs to be noted that in some other embodiments, the metal anode in the metal anode layer may be located in a layer as the same as the second signal line in the second anode layer, that is, the metal anode layer and the second anode layer belong to a same layer. The first insulating layer and the second insulating layer can belong to a same layer. The metal anode in the metal anode layer can also be located in a layer different from the second anode layer, and the metal anode layer and the second anode layer are separated and insulated by the second insulating layer.

The light-emitting layer 294 is disposed on the anode layer 293. The light-emitting layer 294 includes a pixel definition layer 2942. The pixel definition layer 2942 has a plurality of pixel holes. Each pixel hole is provided with the second pixel 226. The material of the second pixel 226 includes an organic light-emitting material.

The common electrode layer 295 is disposed on the light-emitting layer 294. The anode layer 293 and the common electrode layer 295 are disposed at two sides of the second pixel 226 respectively and cooperate with each other to drive the second pixel 226. The common electrode layer 295 can be made of a material such as Mg and Ag.

The planarization layer 296 may also be disposed on the common electrode layer 295. After the second pixel 226 is disposed in the pixel hole, the second pixel 226 does not fill up the pixel hole. After the common electrode layer 295 is disposed on the second pixel 226, a groove may appear. The planarization layer 296 can fill up the groove and cover the entire light-emitting layer 294 so as to protect the light-emitting layer 294 and the like.

A touch sensitive layer 297 may be further provided on the planarization layer 296. The touch layer 297 can be used to detect a user touch operation.

A polarizer (not shown) can also be provided on the touch sensitive layer 297. The polarizer can be used to prevent internal light rays from being transmitted out and prevent a user from seeing the internal components such as the driving units and the like. The touch sensitive layer 297 and the polarizer can be adhered to each other and then be disposed on the planarization layer 296.

It needs to be noted that in some other embodiments, part of the structures can be added or reduced as needed, and the embodiments of the present application are not limited thereto. For example, at least one of the touch sensitive layer 297 or the polarizer can be discarded. For another example, a protective layer can be added between the planarization layer 296 and the touch sensitive layer 297. The protective layer can be made of a material as the same as the substrate 291.

The first display region 240 may utilize a structure similar to that of the second display region 220. Please refer to the foregoing embodiments for details, which will not be elaborated herein. The main difference between the first display region 240 and the second display region 220 is the first driving circuit layer 298. The first driving circuit layer 298 of the first display region 240 and the first driving circuit layer 298 of the second display region 220 are adjacent to each other and belong to a same layer. All the layer structures in the first display region 240 except the driving circuit layer use light-transmitting materials for increasing the light transmittance of the first display region. For example, the substrate, the pixel definition layer, the common electrode layer, the planarization layer and the touch sensitive layer of the first display region 240 can be made of light-transmitting materials. The signal lines in the anode layer can be made of light-transmitting materials such as nano silver. The metal anode in the first display region can be made of a light-transmitting material such as ITO. The common electrode layer can be made of a light-transmitting material such as ITO. The TFT of the driving circuit layer in the first display region cannot be made of light-transmitting materials, but other parts of the driving circuit layer of the first display region except the TFT can also be made of light-transmitting materials. It can be understood that the solutions of increasing the light transmittance of the first display region 240 by increasing the light transmittance of a material and changing the layout are within the scope of the present application. It needs to be noted that the substrate, the pixel definition layer, the common electrode layer, the planarization layer and touch sensitive layer of the first display region 240 can also be made of light-transmitting materials that are as the same as that of the second display region 220. For example, the substrate can be made of a light-transmitting material such as glass or resin.

In order to increase the light transmittance of the first display region, it can be arranged that the size of the first pixels in the first display region is greater than the size of the second pixels, the size of the first pixels in the first display region is greater than the size of the second pixels, and the spacing between the first pixels is positively correlated with the size of the first pixels, that is, the larger the size of the first pixels, the greater the separated distance between the first pixels. Therefore, the distribution density of the first pixels in the first display region is less than the distribution density of the second pixels in the second display region. The light transmittance of the pixel definition layer between the first pixels is greater than the light transmittance of the first pixels. Therefore, the larger the size of the first pixels, the higher the light transmittance of the first display region.

In order to increase the light transmittance of the first display region, it can also be arranged that the distribution density of the first pixels is less than the distribution density of the second pixels. The size of the first pixels in the first display region is equal to the size of the second pixels. The separated distance between the first pixels increases such that the distribution density of the first pixels is less than the distribution density of the second pixels. The light transmittance of the pixel definition layer between the first pixels is greater than the light transmittance of the first pixels. Therefore, the lower the distribution density of the first pixels, the greater the separated distance between the first pixels and the higher the light transmittance of the first display region. For example, the second pixels in the second display region may reach 400 ppi or more, the size of the first pixels in the first display region may be four times that of the second pixels, and the first pixels in the first display region may reach 200 ppi.

In order to increase the light transmittance of the first display region, the first driving units provided in the first display region may be of a simple driving circuit. Specifically, the second display region includes a plurality of second driving units, and one second driving unit drives one second pixel. The first driving unit in the first display region may be of a driving circuit that is simpler than the second driving unit in the second display region. The number of the thin-film transistors included in the first driving unit is less than the number of the thin-film transistors of the second driving unit. Because the thin-film transistors are opaque, the number of opaque thin-film transistors in the first driving unit is small, the occupied area is small, opaque regions of the driving circuit layer are small in number, and light-transmitting regions in the driving circuit layer occupies a large proportion. This can increase the light transmittance of the driving circuit layer and the first display region. For example, the second driving unit is of a 7T1C driving circuit, and the first driving unit may be of a 5T1C or 2T1C driving circuit.

In order to increase the light transmittance of the first display region, it can also be arranged that the distribution density of the first driving units is less than the distribution density of the second driving units. The plurality of first pixels of the first display region can be divided into a plurality of first pixel sets, that is, the first display region includes a plurality of first pixel sets, and each of the first pixel sets includes at least two first pixels. The first pixels and the second pixels have a same physical structure. All the first pixels in the first pixel set share a first driving unit. The light-emitting layer in the first display region and the second display region can be formed in a same process, and there is no difference between the light emitting layer of the first display region and the light-emitting layer of the second display region. In the second display region, one second driving unit drives one second pixel. In the first display region, one first driving unit drives a plurality of first pixels. This can reduce the number of the first driving units and reduce the distribution density of the first driving units. The number of the first driving units per unit area is smaller than the number of the second driving units per unit area. Compared to the second display region, the light transmittance of the first display region can be improved. The number of the thin-film transistors included in the first driving unit is less than the number of the thin-film transistors of the second driving unit, and therefore the light transmittance of the first display region is further improved.

The plurality of first pixels in the first pixel set may be connected in parallel to one another or connected in series with one another. It needs to be noted that a larger driving voltage is needed for the serial connection, and the driving voltage of the first driving units connected in parallel is similar to that of the second driving units. It is much difficult to rise up the driving voltage of the driving units. The number of the first pixel sets formed by the first pixels connected in parallel may be larger than the number of the first pixel sets formed by the first pixels connected in series.

The first pixels and the second pixels have a same physical structure, and this can be understood as a meaning that the first pixels and the second pixels have a same size, a same distribution density or a same arrangement. The arrangement can be one of a standard RGB arrangement, a Pentile arrangement or a Delta arrangement.

Connecting the first pixels in parallel can be realized by connecting the first pixels in parallel in the light-emitting layer and can also be realized by connecting the metal anodes in parallel in the anode layer.

The display apparatus further includes a polarizer. The polarizer can have a first polarizing portion corresponding to the first display region, and the first polarizing portion can be a through hole or of a light-transmitting material. For example, a through hole is first provided corresponding to the first display region, and then a transparent material is filled up in the through hole to form the first polarizing portion. For another example, a through hole is first provided corresponding to the first display region, and a material with high light transmittance and low population is filled up in the through hole to form the first polarizing portion such that the first polarizing portion can not only realize high light transmittance property, but also prevent light rays from reflecting away, resulting in seeing the internal structure by the user.

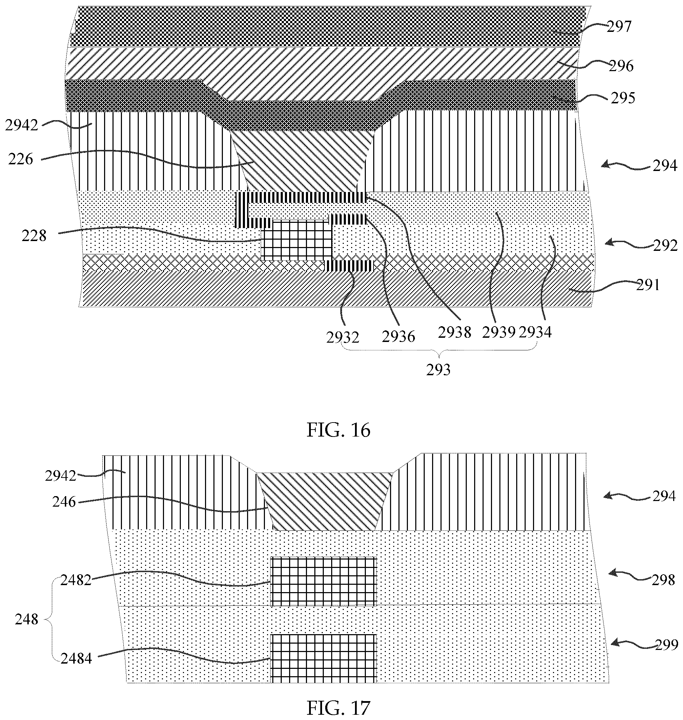

The laminated structure of the first display region may also be a structure of another type, and the embodiments of the present application are not limited thereto. For example, please refer to FIG. 16 for some other embodiments. FIG. 16 is a schematic diagram illustrating a fourth type of laminated structure of a first display region in a display apparatus provided in an embodiment of the present application. The difference between the laminated structure of the first display region in this embodiment and the foregoing embodiments lies in the driving circuit layer and the anode layer. The source and the drain of the thin-film transistor of the first driving unit of the first display region are located in a same layer, and the source is located between the gate of the thin-film transistor and the light-emitting layer.

The anode layer 293 is partially disposed on the driving circuit layer 292. The anode layer 293 includes a first anode layer 2932, a first insulating layer 2934 and a second anode layer 2936. The first insulating layer 2934 is disposed between the first anode layer 2932 and the second anode layer 2936 and is configured to separate and insulate the first anode layer 2932 and the second anode layer 2936. The first anode layer 2932 includes a first signal line (gate line) in a first direction, and the second anode layer 2936 includes a second signal line (data line) in a second direction. The first direction and the second direction can be arranged to be perpendicular to each other. The first signal line and the second signal line are electrically connected to the second driving unit 228, and the driving chip of the display apparatus controls the second driving unit 228 through the first signal line and the second signal line. The first signal line and the gate of the second driving unit 228 may be located in a same layer. The second signal line and the drain of the second driving unit 228 may be located in a same layer. The anode layer 293 may also include a metal anode layer 2938. The metal anode layer 2938 is adjacent to the light-emitting layer 294. The metal anode of the metal anode layer 2938 and the second pixel 226 of the light-emitting layer 294 are directly adjacent to each other and are electrically connected to each other. There is a second insulating layer 2939 between the metal anode layer 2938 and the source of the second driving unit 228. The metal anode can be electrically connected to the source of the second driving unit 228 via a pixel via. A light shielding block 280 is disposed on the second insulating layer 2939 between the metal anode layer 2938 and the second anode layer 2936.

The embodiments of the present application also provide another display apparatus. The difference between the display apparatus of this embodiment and the display apparatus of the foregoing embodiments lies in the arrangement of the thin-film transistors of the first driving unit. In this embodiment, the thin-film transistors of the first driving unit may be all disposed in the first display region, and the thin-film transistors of the first driving unit can be partly disposed in the first driving circuit layer and partly disposed in another driving circuit layer (a second driving circuit layer). In this way, the light transmittance of the first display region can also be improved. Please refer to FIG. 17 for details. FIG. 17 is a schematic diagram illustrating a second type of laminated structure of a first display region in a display apparatus provided in an embodiment of the present application. The first display region includes a first driving circuit layer 298 and a second driving circuit layer 299 that are stacked together. At least one thin-film transistor in the first driving unit 248 is located in the structure first driving circuit layer 298, and at least one thin-film transistor in the first driving unit 248 is located in the second driving circuit layer 299.The thin-film transistors in the first driving circuit layer 298 are at least partially disposed with respect to the thin-film transistors in the second driving circuit layer 299. The opaque thin-film transistors in the first driving unit 248 can be stacked together to reduce the opaque area in the first display region, thereby increasing the light transmittance of the first display region.

Similarly, the thin-film transistors in the first driving unit 248 can be divided into driving transistors 2482 and control transistors 2484. The gate of each control transistor 2484 is electrically connected to the gate line. Each of the driving transistors 2482 is located in the structure first driving circuit layer 298 and each of the control transistors 2484 is located in the second driving circuit layer 299. It can facilitate the layout since the thin-film transistors of each driving unit are divided into control transistors and driving transistors, which are disposed in different layers, and all the gates of the control transistors are electrically connected to the gate line.

The first driving circuit layer 298 is located between the light-emitting layer and the second driving circuit layer 299. Of course, it can also be that the second driving circuit layer is located between the light-emitting layer and the first driving circuit layer.

In the case that the first driving circuit layer 298 is located between the light-emitting layer and the second driving circuit layer 299, each first pixel in the first display region is connected to a power supply voltage via a wire. The longer the wire length, the greater the resistance of the wire. Inevitably, a voltage drop (IR DROP) will be caused on the wire for the power supply voltage. The resistance of the wire makes the power supply voltage obtained by each first driving unit 248 different such that in the presence of a same data signal voltage input, the first pixels have different currents and different brightness outputs. The entire display apparatus results in uneven display brightness. Also, the IR drop of the first pixels may differ for different displayed images. The control transistor 2484 in the first driving unit 248 plays a control role and is not sensitive to the IR drop. When the control transistor is placed in the second driving circuit layer 299, it does not affect turning on and off the control transistor 2484 and has no effect on color compensation of the first display region even though the IR drop of the power supply voltage and the voltage signal of the control transistor 2484 is large. The driving transistor 2482 in the first driving unit 248 plays a role of driving the first pixel. When the driving transistor 2482 is disposed in the first driving circuit layer 298, the voltage drop (IR Drop) will be relatively small since it is close to the first pixel, that is, it is easier to compensate the color of the first display region when the IR drop of the power supply voltage and the voltage signal of the first pixel is small.

The driving transistor 2482 and the control transistor 2484 overlap with each other as much as possible. If there are more driving transistors 2482, the driving transistors 2482 cover the control transistors 2484. Similarly, if there are more control transistors 2484, the control transistors 2484 cover the driving transistors 2482. This makes the first display region have the largest transparent area.

It needs to be noted that because the light transmittance of the first pixel is lower than the light transmittance of the pixel definition layer, the driving transistors 2482 and the first pixel may be at least partially disposed opposite to each other such that the light transmittance of the first display region is improved. It can also be understood that the orthographic projection of the driving transistors 2482 onto the light-emitting layer at least partially overlaps with the first pixel. Because the area of the driving transistors 2482 is smaller than the area of the first pixel, the orthographic projection of the driving transistors 2482 onto the light-emitting layer is within the first pixel, that is, the first pixel covers the driving transistors 2482. This can increase the light transmittance of the first display region. If the control transistors 2484 are disposed in the first display region, the orthographic projection of the control transistors 2484 onto the light-emitting layer is also within the first pixel.

It needs to be noted that the laminated structure of the first display region and the structure of the first pixel in this embodiment may be as the same as the structure of the foregoing embodiments, and this will not be elaborated herein.

The lens of the camera in the electronic equipment faces the substrate of the display apparatus, and the camera is configured to capture external light signals passing through the first display region for forming an image. In order to reduce the space occupied by the camera, the lens of the camera can be disposed close to or adjacent to the substrate of the display apparatus. The substrate of the display apparatus is mainly configured to support other layer structures of the display apparatus, and special functions are not required for the substrate. In order to further reduce the space occupied by the camera, the camera can be partially disposed in the substrate. Please refer to FIG. 13 for details. FIG. 13 is a schematic diagram illustrating a first type of structure of a camera and a display apparatus provided in an embodiment of the present application. A first mounting hole is provided at a position on the substrate corresponding to the camera 60, and the camera 60 is at least partially disposed in the first mounting hole. The first mounting hole can be a blind hole, that is, the thickness of the part of the substrate 291 corresponding to the camera 60 is less than the thickness of other parts. The substrate 291 is still a complete substrate 291, and its function of supporting other layer structures of the display apparatus 20 is not affected and some space can be got to accommodate the camera 60. The installation of the first mounting hole and the camera 60 can be provided based on the size of the first mounting hole and the size of the camera 60. For example, if the first mounting hole has insufficient space for installing the entire camera 60, the lens 62 of the camera 60 is partially disposed in the first mounting hole. If the camera 60 is sufficiently small, the entire camera 60 is disposed in the first mounting hole.

It needs to be noted that the camera 60 corresponding to the first display region 240 can be used as a front camera 60 of the electronic device. The front camera is generally a camera with a lens that cannot be moved. The substrate 291 of the display apparatus can be provided with a first mounting hole. The camera 60 corresponding to the display region 240 may be a camera 60 with a movable lens 62, and the movable lens 62 of the camera 60 may be used for realizing auto-focusing and the like.

It can be understood that in any of the foregoing embodiments, the size and shape of the first pixels in the first display region can be configured as required. For example, the first pixel may be a rectangle or of a circle-like shape. The circle-like shape of the first pixel may be a circle, an oval, a rectangle with rounded corner, or the like. Since the periphery of the first pixel having the circle-like shape is transitioned with arcs, the diffraction problem in the first display region can be improved.

The display apparatus may have a regular shape, such as a rectangle, a rectangle with rounded corners, or a circle. Of course, in some other possible embodiments, the display apparatus may also have an irregular shape, and the embodiments of the present application are not limited thereto.

One or more cameras can be disposed under the first display region. The plurality of cameras can be cameras that cooperate with each other, such as two identical cameras, that is, an ordinary camera, and a blurring camera or a black-and-white camera, in addition to the camera, other functional devices, such as proximity sensors, light sensors, rangefinders and fingerprint recognition sensors, can be disposed below the first display region.

In order to have a more comprehensive understanding of the electronic device in the embodiment of the present application, the structure of the electronic device will be further described below. Referring to FIG. 1 again, the electronic device 10 further includes a housing 40 and a camera 60.

The housing 40 may include a back cover (not shown) and a frame 420. The frame 420 is disposed around the periphery of the back cover. The display apparatus 20 may be disposed within the frame 420, and the display apparatus 20 and the back cover may be taken as two opposite sides of the electronic device 10. The camera 60 is provided between the back cover of the housing 40 and the display apparatus 20. The display device 20 may be an organic light-emitting diode (OLED) display device 20. The display apparatus 20 may be a full-screen display, that is, the entire surface of the display apparatus 20 is basically the display region. A cover plate may also be provided on the display apparatus 20. The cover plate covers the display apparatus 20 so as to protect the display apparatus 20 and prevent the display apparatus 20 from being scratched or damaged by water. The cover plate may be a transparent glass cover plate such that the user can perceive the information displayed by the display apparatus 20 through the cover plate. For example, the cover plate may be a cover plate made of sapphire.

The electronic device may also include a circuit board, a battery and a middle plate. The frame 420 is disposed around the middle plate. The frame 420 and the middle plate can form a middle frame of the electronic device 10. The middle plate and the frame 420 form a receiving cavity at each of two sides of the middle plate. One receiving cavity is used for receiving the display apparatus 20, and the other receiving cavity is used for receiving the circuit board, the battery, and other electronic elements or functional components of the electronic device 10.

The middle plate may have a thin-plate or sheet-like structure, or a hollow frame structure. The middle frame provides support for the electronic elements or functional components in the electronic device 10 so as to assembly the electronic elements and the functional components in the electronic device 10 together. The functional components such as the camera 60, receiver and battery of the electronic device 10 can be all mounted on the middle frame or the circuit board and be fastened thereto. It can be understood that the material of the middle frame may include metal or plastic.

The circuit board can be mounted on the middle frame. The circuit board may be a mother board of the electronic device 10. One or more of functional components, such as a microphone, a speaker, a receiver, a headphone interface, an acceleration sensor, a gyroscope and a processor, can be integrated on the circuit board. Also, the display apparatus 20 may be electrically connected to the circuit board to control the displaying of the display apparatus 20 by a processor on the circuit board. Both the display apparatus 20 and the camera 60 may be electrically connected to the processor. When the processor receives a shooting instruction, the processor controls the light-transmitting region to terminate the displaying and controls the camera 60 to capture images through the first display region 240. When the processor receives an image displaying instruction without receiving the shooting instruction, the processor controls the second display region 220 and the first display region 240 to display images together.

The battery can be mounted on the middle frame. Also, the battery is electrically connected to the circuit board for realizing power supply to the electronic device 10. A power management circuit may be provided on the circuit board. The power management circuit is used to distribute the voltage provided by the battery to various electronic components in the electronic device 10.

It should be understood that the "plurality" mentioned herein refers to two or more than two.

The electronic device and the method for controlling the lens of the decorative element provided in the embodiments of the present application are described in detail above. The principles and implementations of the present application are set forth herein with reference to specific examples, descriptions of the above embodiments are merely served to assist in understanding the present application. In addition, persons of ordinary skill in the art can make variations and modifications to the present application in terms of the specific implementations and application scopes according to the ideas of the present application. Therefore, the content of specification shall not be construed as a limit to the present application.

## Claims

1. A display apparatus, comprising a first display region and a second display region that are adjacent to each other,
wherein the first display region comprises a plurality of first driving units, at least one of the first driving units comprises at least two thin-film transistors, at least one thin-film transistor in the first driving unit is located in the first display region, and at least one thin-film transistor in the first driving unit is located in the second display region.

2. The display apparatus of claim 1, further comprising a gate line, wherein the plurality of thin-film transistors of the first driving unit comprises at least one driving transistor and at least one control transistor, and a gate of the control transistor is electrically connected to the gate line; and
all of the driving transistors are disposed in the first display region and all of the control transistors are disposed in the second display region.

3. The display apparatus of claim 2, further comprising a light-emitting layer, wherein the light-emitting layer comprises a plurality of first pixels, the plurality of first driving units are configured to drive the plurality of first pixels, and an orthographic projection of the driving transistors onto the light-emitting layer at least partially overlaps with the first pixel.

4. The display apparatus of claim 3, wherein a projection of the driving transistors onto the light-emitting layer is within the first pixel.

5. The display apparatus of claim 3, wherein the first display region comprises a plurality of first pixel sets, each of the first pixel sets comprises at least two of the first pixels, and one first driving unit is configured to drive all of the first pixels in one first pixel set.

6. The display apparatus of claim 5, wherein all of the first pixels in each of the first pixel sets are connected in parallel to one another.

7. The display apparatus of claim 6, wherein the second display region comprises a plurality of second pixels, and the first pixels and the second pixels have a same physical structure.

8. The display apparatus of claim 1, wherein the first driving unit further comprises a capacitor located in the first display region.

9. The display apparatus of claim 1, wherein a light transmittance of the first display region is greater than a light transmittance of the second display region.

10. The display apparatus of claim 9, wherein the first display region comprises a plurality of first pixels, the second display region comprises a plurality of second pixels, and a size of the first pixels is greater than a size of the second pixels.

11. The display apparatus of claim 9, wherein the first display region comprises a plurality of first pixels, the second display region comprises a plurality of second pixels, and a distribution density of the first pixels is less than a distribution density of the second pixels.

12. The display apparatus of claim 11, wherein the second display region comprises second driving units, the second driving units drive the plurality of second pixels, and a number of thin-film transistors of the second driving unit is greater than or equal to a number of thin-film transistors of the first driving unit.

13. A display apparatus, comprising a first display region, the first display region comprising:
a first driving circuit layer and a second driving circuit layer that are stacked together; and a plurality of first driving units, wherein at least one of the first driving units comprises at least two thin-film transistors, at least one thin-film transistor in the first driving unit is located in the first driving circuit layer, at least one thin-film transistor in the first driving unit is located in the second driving circuit layer, the thin-film transistors in the first driving circuit layer are at least partially disposed with respect to the thin-film transistors in the second driving circuit layer.

14. The display apparatus of claim 13, further comprising a gate line, the plurality of thin-film transistors of the first driving unit are divided into driving transistors and control transistors, a gate of the control transistor is electrically connected to the gate line, each of the driving transistors is located in the is first driving circuit layer, and each of the control transistors is located in the second driving circuit layer.

15. The display apparatus of claim 14, further comprising a light-emitting layer, wherein the light-emitting layer comprises a plurality of first pixels, and the plurality of first driving units are configured to drive the plurality of first pixels; and
the first driving circuit layer is located between the light-emitting layer and the second driving circuit layer.

16. The display apparatus of claim 15, wherein the first display region comprises a plurality of first pixel sets, each of the first pixel sets comprises at least two of the first pixels, and one first driving unit is configured to drive all of the first pixels in one first pixel set.

17. The display apparatus of claim 16, wherein all of the first pixels in each of the first pixel sets are connected in parallel to one another.

18. The display apparatus of claim 17, wherein the second display region comprises a plurality of second pixels, and the first pixels and the second pixels have a same physical structure.

19. The display apparatus of claim 13, further comprising a second display region adjacent to the first display region, wherein a light transmittance of the second display region is less than a light transmittance of the first display region.

20. An electronic device, comprising a display apparatus and a sensor, wherein the display apparatus is the display apparatus according to any of claims 1-19, and the sensor transmits signals passing through the first display region.
